# DEMANDE DE BREVET EUROPEEN

(11) **EP 3 745 468 A1**
(43) Date de publication de la demande: **02.12.2020**
(21) Numéro de dépôt: 20175377.9
(22) Date de dépôt: 19.05.2020
(51) Int. Cl.: H01L 29/78, H01L 29/40, H01L 21/336, H01L 29/08, H01L 29/423

(54) **STRUCTURE DE TRANSISTOR**

(30) Priorité: 28.05.2019 FR 1905661
(71) Demandeur: STMicroelectronics (Rousset) SAS, 13790 Rousset (FR)
(72) Inventeur: GERMANA-CARPINETO, Rosalia, 06600 ANTIBES (FR)
(74) Mandataire: Cabinet Beaumont

(57) **Abrégé**

La présente description concerne un transistor (T110) comprenant : une région semiconductrice (160) d'un substrat (102), délimitée par une tranchée (170) ; un élément électriquement conducteur (180) situé dans la tranchée (170) ; une zone de canal (130) en contact avec ladite région semiconductrice (160) ; et une prise de contact (150) avec ladite région (160), la zone de canal (130) et la prise de contact (150) étant du côté d'une même face du substrat.

## Description

### Domaine technique

La présente description concerne de façon générale les dispositifs électroniques, et plus particulièrement des transistors.

### Technique antérieure

Dans certains dispositifs électroniques, des transistors à effet de champ, par exemple de type MOS, sont utilisés à un état non passant pour bloquer des tensions élevées, typiquement supérieures à 10 V, par exemple de l'ordre de 40 V, voire supérieures à 100 V. Plus le transistor est petit et/ou plus la tension bloquée à l'état non passant est élevée, plus la résistance du transistor à l'état passant est élevée.

### Résumé de l'invention

Il existe un besoin d'améliorer, dans les transistors, le compromis entre la résistance à l'état passant, les dimensions, et la tension bloquée à l'état non passant.

Un mode de réalisation pallie tout ou partie des inconvénients des transistors connus.

Un mode de réalisation permet de réduire la résistance à l'état passant et/ou de réduire la surface occupée et/ou d'augmenter la tension bloquée.

Ainsi, un mode de réalisation prévoit un transistor comprenant : une région semiconductrice d'un substrat, délimitée par une tranchée ; un élément électriquement conducteur situé dans la tranchée ; une zone de canal en contact avec ladite région semiconductrice ; et une prise de contact avec ladite région, la zone de canal et la prise de contact étant du côté d'une même face du substrat.

Selon un mode de réalisation, une partie de la région semiconductrice est située entre la zone de canal et ladite prise de contact.

Selon un mode de réalisation, la région semiconductrice est délimitée, d'un côté opposé à celui de ladite tranchée, par une tranchée supplémentaire, et un élément électriquement conducteur supplémentaire est situé dans la tranchée supplémentaire.

Selon un mode de réalisation, une partie de l'élément supplémentaire est en vis-à-vis de la zone de canal.

Selon un mode de réalisation, le transistor comprend une grille située dans la tranchée.

Selon un mode de réalisation, la tranchée atteint un caisson enterré.

Selon un mode de réalisation, une partie de la région semiconductrice est située entre la zone de canal et le caisson enterré.

Selon un mode de réalisation, une partie de l'élément conducteur est située en vis-à-vis de ladite partie de la région semiconductrice.

Selon un mode de réalisation, la zone de canal atteint le caisson enterré.

Selon un mode de réalisation, le transistor comprend, d'un côté de la zone de canal opposé à la région semiconductrice, une région semiconductrice supplémentaire en contact avec la zone de canal, et une prise de contact supplémentaire avec ladite région semiconductrice supplémentaire.

Selon un mode de réalisation, le transistor comprend un autre élément conducteur situé dans la tranchée en vis-à-vis de ladite région semiconductrice supplémentaire.

Selon un mode de réalisation, la région semiconductrice présente, à partir de la prise de contact avec ladite région, des niveaux de dopage décroissants.

Selon un mode de réalisation, le transistor comprend une zone dopée recouvrant une partie de la zone de canal, ladite zone dopée étant de préférence reliée électriquement à l'élément conducteur.

Selon un mode de réalisation, ladite zone dopée comprend une branche s'étendant entre l'élément conducteur et une prise de contact avec la zone de canal.

Un mode de réalisation prévoit un dispositif électronique comprenant un ou plusieurs transistors tels que décrits.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière partielle et schématique, une vue de dessus 1A, et des vues en coupe 1B, 1C, et 1D d'un mode de réalisation d'un dispositif comprenant un transistor ;
la figure 2 représente, de manière partielle et schématique, une vue en perspective du dispositif de la figure 1 ;
la figure 3 représente, de manière partielle et schématique, une vue de dessus 3A, et des vues en coupe 3B, 3C, et 3D, d'une étape d'un exemple de procédé de fabrication du dispositif de la figure 1 ;
la figure 4 représente, de manière partielle et schématique, une vue de dessus 4A, et des vues en coupe 4B, 4C, et 4D, d'une autre étape du procédé ;
la figure 5 représente, de manière partielle et schématique, une vue de dessus d'un autre mode de réalisation d'un dispositif comprenant un transistor ; et
la figure 6 représente, de manière partielle et schématique, une vue en perspective du dispositif de la figure 5.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, des étapes de fabrication de masques, des étapes de dopage, et de fabrication de bornes sur des zones dopées ne sont pas détaillées, les modes de réalisation décrits étant compatibles avec des telles étapes usuelles.

Sauf précision contraire, lorsque l'on fait référence à deux éléments connectés entre eux, cela signifie directement connectés sans éléments intermédiaires autres que des conducteurs électriques, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des vues en coupe.

Sauf précision contraire, les expressions "environ", "approximativement", "sensiblement", et "de l'ordre de" signifient à 10 % près, de préférence à 5 % près.

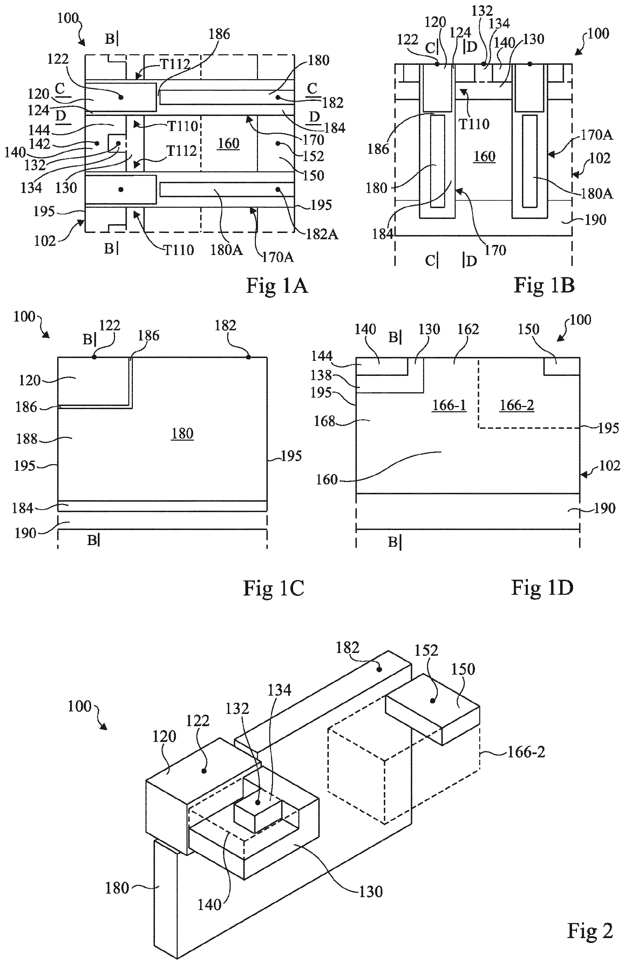

La figure 1 représente, de manière partielle et schématique, une vue de dessus 1A, et des vues en coupe 1B, 1C, et 1D, d'un mode de réalisation d'un dispositif 100 comprenant un transistor. Les vues en coupe 1B, 1C, et 1D, ont pour plans de coupe respectifs des plans B-B, C-C, D-D. La figure 2 représente une vue en perspective schématique et partielle du dispositif 100. Notamment, des isolants électriques, une région dopée et un caisson enterré ne sont pas représentés en figure 2.

Le dispositif 100 est typiquement une puce électronique de circuit intégré, définie par un substrat semiconducteur 102 et des éléments, tels que des composants électroniques, situés dans et sur le substrat 102.

Dans un exemple, le substrat 102 est constitué par une tranche semiconductrice, par exemple une tranche de silicium. Dans un autre exemple, le substrat est constitué par une couche située sur la surface d'une tranche semiconductrice, par exemple une couche épitaxiée sur une tranche semiconductrice. De préférence, le substrat 102 est monocristallin.

Parmi les composants électroniques, le dispositif 100 comprend un ou plusieurs transistors. En particulier, le dispositif 100 comprend un transistor T110 à effet de champ, ou plusieurs transistors T110 connectés électriquement en parallèle. Le transistor T110 comprend notamment :
- une grille 120 connectée à une borne de commande 122 du transistor ;
- une zone de canal 130 séparée de la grille 120 par un isolant de grille 124. La zone de canal 130 est de préférence connectée, par l'intermédiaire d'une prise de contact 134, à une borne 132, dite borne de corps du transistor ; et
- des zones dopées 140 et 150 de drain/source situées de part et d'autre de la zone de canal 130 et en contact avec des bornes respectives 142 et 152 de conduction. Selon un mode de réalisation, la zone dopée 140 recouvre une partie de la zone de canal 130.

Le transistor T110 est situé du côté d'une face avant (face supérieure) du substrat 102. En particulier, des éléments tels que la grille 120, la zone de canal 130, et les zones dopées 140 et 150 sont situées du côté de la face avant du substrat, c'est-à-dire qu'ils présentent, du côté de la face avant, chacun une face non recouverte par une partie du substrat 102. De ce fait, les bornes 132, 142 et 152 peuvent être définies par des conducteurs situés sur ces éléments, par exemple des vias traversant une couche isolante recouvrant le dispositif. Les connections permettant de relier électriquement le transistor T110 à d'autres composants du dispositif ou à un dispositif extérieur, sont alors plus faciles à réaliser que si, par exemple, la zone dopée 150 était située côté face arrière.

De préférence, la borne de conduction 142 et la borne de corps 132 sont électriquement reliées, de préférence connectées, entre elles. La borne 142 correspond alors à la borne de source du transistor T110, et la borne 152 correspond à la borne de drain du transistor T110. Les zones dopées 140 et 150 définissent alors des zones respectives de drain et de source. Ceci n'est pas limitatif, les bornes 132 et 142 pouvant par exemple ne pas être reliées ou connectées entre elles.

La grille 120 comprend au moins un conducteur électrique tel que par exemple un métal et/ou du silicium polycristallin dopé. L'isolant de grille 124 est en contact avec la zone de canal 130 et avec un conducteur électrique de la grille 120. L'isolant de grille 124 est typiquement constitué d'une ou plusieurs couches diélectriques, par exemple l'isolant de grille est constitué d'une couche d'oxyde de silicium. L'épaisseur de l'isolant de grille est typiquement inférieure à 15 nm, de préférence comprise entre 3 et 10 nm.

A titre d'exemple, le transistor T110 est du type à canal N. Ainsi, les zones dopées 140 et 150 sont dopées de type N. La zone de canal 130 est dopée de type P. Cependant, dans les modes de réalisation décrits, les types de conductivité N et P, ou types de dopage, peuvent être échangés. Des fonctionnements similaires à ceux décrits sont alors obtenus en échangeant les signes des tensions dans le dispositif. De préférence, les niveaux de dopage des zones 140 et 150 sont élevés, c'est-à-dire supérieurs à 5*10¹⁸ atomes/cm³, de préférence supérieurs à 10¹⁹ atomes/cm³. La prise de contact 134 avec la zone de canal 130 est une zone dopée ayant également un tel niveau de dopage élevé. Le niveau de dopage de la zone de canal 130 est de préférence inférieur à 10¹⁸ atomes/cm³, plus préférentiellement inférieur à 5*10¹⁷ atomes/cm³.

Le transistor T110 comprend en outre une région semiconductrice 160 (non représentée en figure 2), dite région de dérive. La région semiconductrice 160 est isolée de la zone dopée 140 par la zone de canal 130. La région semiconductrice 160 comprend au moins une partie 162 (vue 1D) située entre la zone de canal 130 et la zone dopée 150. La distance séparant la zone de canal 130 de la zone dopée 150 est par exemple comprise entre 1 et 5 µm, préférentiellement entre 2 et 4 µm. La région semiconductrice 160 a un niveau de dopage de type N inférieur à celui de la zone dopée 150 de type N. De préférence, la région semiconductrice 160 a un niveau de dopage faible, c'est-à-dire inférieur à 2*10¹⁷ atomes/cm³. Ce niveau de dopage est de préférence supérieur à 5*10¹⁶ atomes/cm³. Du fait de son niveau de dopage plus élevé que celui de la région semiconductrice 160, la zone dopée 150 constitue une prise de contact électrique avec la région semiconductrice 160.

A l'état bloqué du transistor, la région de dérive 160, du fait de son faible niveau de dopage, bloque une tension élevée, telle que mentionnée en préambule, entre la zone de canal 130 et la prise de contact 150. A l'état passant du transistor, un courant traversant le transistor circule dans la région de dérive 160, de la prise de contact 150 à la zone de canal 130.

La région semiconductrice 160 est délimitée par une tranchée 170. Plus précisément, la tranchée 170 s'étend dans le substrat 102 à partir de la face avant du substrat 102, et une paroi de la tranchée 170 constitue une face latérale de la région semiconductrice 160. De préférence, cette paroi de la tranchée 170 constitue également une face de la zone de canal 130. A titre d'exemple, la tranchée a une largeur comprise entre 100 et 500 nm.

Le transistor T110 comprend en outre un élément électriquement conducteur 180 situé dans la tranchée 170. L'élément conducteur 180 est connecté à une borne 182. La borne 182 est de préférence connectée à la borne de corps 132. L'élément conducteur 180 est situé en vis-à-vis d'au moine une partie de la région semiconductrice 160, c'est-à-dire que l'élément conducteur 180 est situé contre un isolant 184 recouvrant la face latérale d'au moins une partie de la région semiconductrice 160. En particulier, l'élément conducteur est situé en vis-à-vis de la partie 162 située entre la zone de canal 130 et la zone dopée 140. De préférence, l'élément conducteur 180 est situé en vis-à-vis de toute la région semiconductrice 160 ou de sensiblement toute la région semiconductrice 160. La couche isolante 184 sépare l'élément conducteur 180 de la région semiconductrice 160. La distance entre l'élément conducteur 180 et la région semiconductrice 160, correspondant à l'épaisseur de la couche isolante 184, est par exemple comprise entre 100 nm et 200 nm, de préférence, comprise entre 120 nm et 180 nm. La couche isolante 184 a de préférence une épaisseur supérieure à celle de l'isolant de grille 124. A titre d'exemple, la couche isolante 184 est en oxyde de silicium ou en nitrure de silicium.

Au fond de la tranchée 170, une portion isolante, de préférence une portion de la couche 184, est située sous l'élément conducteur 180. Cette portion isole électriquement l'élément conducteur 180 de la partie du substrat située sous l'élément conducteur 180. En outre, des portions isolantes 186, de préférence de même épaisseur et de même matériau ou matériaux que l'isolant de grille 124, isolent électriquement l'élément conducteur 180 de la grille 120.

De préférence, l'élément conducteur 180 est constitué par un mur conducteur situé dans une partie centrale de la tranchée 170. Le mur est allongé dans la même direction que la tranchée. Le mur s'étend dans le substrat 102 orthogonalement à la face avant du substrat. A titre d'exemple, le mur comprend, de préférence est constitué par, un matériau métallique ou, préférentiellement, du silicium polycristallin dopé. La largeur du mur conducteur, prise dans la direction de largeur de la tranchée, est par exemple comprise entre 30 nm et 200 nm.

A l'état bloqué du transistor, l'élément conducteur 180 écrante une partie du champ électrique dû à la tension entre la zone de canal 130 et la prise de contact 150. Le champ électrique au niveau de la jonction PN entre la zone de canal 130 et la région semiconductrice 160 est donc plus réduit que si l'élément conducteur 180 n'était pas prévu. Ceci augmente la tension maximum que le transistor peut bloquer.

En l'absence d'élément conducteur 180, pour augmenter la tension maximum que le transistor peut bloquer, on aurait pu penser diminuer le dopage de la région de dérive 160 ou augmenter la distance entre la zone de canal 130 et la prise de contact de drain 150. Cependant, ceci aurait augmenté la résistance de la région de dérive 160, et donc la résistance du transistor à l'état passant. L'élément conducteur 180 permet donc d'augmenter la tension maximum bloquée par le transistor sans augmenter la résistance du transistor à l'état passant. En outre, l'élément conducteur 180 permet d'augmenter le niveau de dopage de la région de dérive 160 et/ou de réduire la distance entre la zone de canal 130 et la prise de contact de drain 150, et ainsi réduire la résistance du transistor à l'état passant, en conservant une tension maximum bloquée au moins égale à celle de transistors dépourvus de l'élément conducteur 180.

De préférence, la région semiconductrice 160 est délimitée, de son côté opposé à la tranchée 170, par une tranchée supplémentaire 170A. La région semiconductrice 160 est alors située entre les tranchées 170 et 170A. La tranchée supplémentaire 170A est parallèle à la tranchée 170, c'est-à-dire que les tranchées 170 et 170A ont la même direction d'allongement. Plus préférentiellement, la tranchée supplémentaire 170A contient des mêmes éléments que la tranchée 170, disposés symétriquement par rapport à la région semiconductrice 160, à savoir, un élément conducteur supplémentaire 180A symétrique de l'élément conducteur 180 et situé en vis-à-vis d'au moins une partie de la région semiconductrice 160. L'élément conducteur 180A est en contact avec une borne 182A, de préférence connectée à la borne 182 de l'élément conducteur 180.

L'élément conducteur supplémentaire 180A permet d'améliorer l'écrantage permis par l'élément conducteur 180. Il en résulte une amélioration supplémentaire de la tension maximum bloquée par le transistor et/ou de la résistance du transistor à l'état passant.

De préférence, la tranchée 170 délimite la zone de canal 130. Plus précisément, la zone de canal a alors une face latérale constituée par la paroi de la tranchée 170. Plus préférentiellement, la grille 120 est alors située dans la tranchée 170 en vis-à-vis de la zone de canal 130. L'isolant de grille 124 recouvre la partie correspondante de la paroi de la tranchée 170.

Du fait que la grille est dans la tranchée, un canal de conduction se forme à l'état passant dans la zone de canal 130 contre la face latérale de la zone de canal 130. Par rapport à une variante dans laquelle la grille 120 est disposée sur la zone de canal 130, on évite que le canal de conduction ait comme largeur la distance entre les tranchées 170 et 170A. Ainsi, le fait de prévoir la grille 120 dans la tranchée 170 permet que la forme du canal de conduction ne dépende pas de la distance sur laquelle la zone de canal 130 s'étend à partir de la tranchée 170. On peut donc réduire cette distance, par exemple rapprocher les tranchées, sans modifier la forme du canal de conduction, par exemple sans réduire sa largeur, et donc sans réduire le courant passant dans le transistor et sans augmenter la résistance du transistor à l'état passant. Ainsi, la surface occupée par le transistor T110 est, pour un même courant et une même résistance à l'état passant, plus réduite que celle d'un transistor ayant sa grille située sur la zone de canal. A titre d'exemple, la largeur de la région semiconductrice 160 dans la direction de largeur des tranchées est comprise entre 300 nm et 1 µm.

L'élément conducteur 180 et la grille 120 situés dans la tranchée font que, dans le transistor T110 à l'état passant, le courant circule dans une partie de la région de dérive 160 plus étendue qu'en l'absence de l'élément conducteur 180 et/ou que si la grille 120 n'était pas située dans la tranchée. En particulier, le courant passe dans des parties de la région de dérive 160 plus éloignées des faces latérales de la région de dérive 160 qu'en l'absence des éléments conducteurs. Le courant passe également dans des parties de la région de dérive 160 plus éloignées de la face supérieure de la région de dérive 160 que si la grille était située sur la zone de canal. Ceci permet de réduire la résistance du transistor à l'état passant, en particulier en réduisant divers effets de la présence des faces de la région de dérive 160 sur la mobilité des porteurs de charge.

Dans un exemple préféré, la région semiconductrice 160 présente, à partir de la prise de contact 150, des niveaux de dopage décroissants. Dans l'exemple représenté, la région semiconductrice 160 comprend deux sous-régions 166-1 et 166-2.

La sous-région 166-2 sépare la sous-région 166-1 de la prise de contact 150. La sous-région 166-2 s'étend à partir de la prise de contact vers la zone de canal 130, sur une distance par exemple comprise entre un tiers et deux tiers, de préférence sensiblement la moitié, de la distance entre la prise de contact 150 et la zone de canal 130. La sous-région 166-2 s'étend à partir de la prise de contact vers la zone de canal 130 sur une distance par exemple comprise entre 0,5 µm et 1,5 µm, de préférence de l'ordre de 1 µm. Le niveau de dopage de la sous-région 166-2 est compris entre celui de la région 166-1 et celui de la prise de contact 150. Le niveau de dopage de la sous-région 166-2 peut-être compris entre 10¹⁷ et 10¹⁸ atomes/cm³.

Cet exemple préféré n'est pas limitatif, la région semiconductrice 160 pouvant comprendre, ou être constituée par, un nombre N de sous-régions semiconductrices 166-i, l'indice i étant compris entre 1 et N. La sous-région 166-N s'étend à partir de la prise de contact 150. Les sous-régions sont placées selon l'indice i décroissant à partir de la prise de contact 150, le niveau de dopage des sous-régions 166-i est une fonction croissante de l'indice i. En variante, la région semiconductrice 160 peut présenter un gradient de niveau de dopage à partir de la prise de contact 150.

Les sous-régions 166-i pour i différent de 1, ou la sous-région à gradient de dopage, constituent une zone à niveau de dopage intermédiaire entre celui de la sous-région 166-1 et celui de la prise de contact 150. Une telle zone permet, pour une résistance donnée à l'état passant, d'obtenir un niveau souhaité de tension maximum bloquée par le transistor. Autrement dit, le fait que niveau de dopage de la région semiconductrice 160 décroît à partir de la prise de contact 150, permet, pour une même tension maximum bloquée par le transistor à l'état bloqué, d'améliorer la résistance à l'état passant du transistor.

Selon un mode de réalisation, la zone de canal 130 est située sur la région semiconductrice 160, plus précisément une partie 168 de la région semiconductrice 160 est située sous la zone de canal 130. Autrement dit, la zone de canal 130 est, par rapport à la partie 168, du côté de la face avant. Une partie 188 de l'élément conducteur 180 est alors, de préférence, située sous la grille 120. La partie 188 de l'élément conducteur se trouve ainsi en vis-à-vis de la partie 168 de la région semiconductrice 160.

Un avantage de prévoir la partie 168 de la région semiconductrice 160 est que, à l'état passant, le canal de conduction du transistor comprend une portion horizontale 138 en contact avec la partie 168, et le courant en provenance de la prise de contact 150 peut rejoindre cette portion 138 du canal en passant par la partie 168 de la région semiconductrice 160. Il en résulte une réduction de la résistance à l'état passant.

Selon un autre avantage, dans le dispositif 100, on peut prévoir en outre des transistors, non représentés, qui diffèrent du transistor T110 comprenant la partie 168 de la région semiconductrice 160, en ce que la prise de contact 150 est omise et remplacée par une prise de contact de drain en face arrière du substrat. Dans de tels transistors, dits transistors verticaux, à l'état passant, le courant circule verticalement entre la zone de canal et la prise de contact de drain. Pour fabriquer, dans le même dispositif, le transistor T110 comprenant la partie 168 de la région 160 et les transistors verticaux, il est possible de mettre en oeuvre des étapes de fabrication simultanée du transistor T110 et des transistors verticaux. Un dispositif comprenant à la fois des transistors verticaux et des transistors T110 est alors particulièrement simple à fabriquer.

De préférence, la zone dopée 140 présente une branche 144 qui s'étend entre la prise de contact 134 avec la zone de canal, et l'élément conducteur 180. Ceci permet, pour une taille donnée de la prise de contact 134, de réduire la longueur du canal conducteur entre la zone dopée 140 et la région semiconductrice 160. On réduit ainsi la résistance à l'état passant.

De préférence, les tranchées 170 et 170A atteignent un caisson enterré 190, c'est-à-dire une région de type de conductivité (ici de type P) opposé à celui du substrat 102 (ici de type N), recouvrant une partie du substrat et recouverte par des régions de même type de conductivité que celui du substrat. Autrement dit, les tranchées s'étendent de la face avant du substrat 102 jusqu'au caisson enterré 190. L'éventuelle partie 168 de la région semiconductrice 160 est ainsi située entre la zone de canal 130 et le caisson enterré 190. Le caisson enterré 190 est polarisable à un potentiel inférieur à celui de la région semiconductrice 160. Pour cela, le caisson enterré 190 est par exemple relié à la masse (non représentée). Le caisson enterré permet ainsi d'isoler électriquement la région semiconductrice 160 du reste du substrat 102. Le transistor T110 peut ainsi être isolé d'autres composants du dispositif, par exemple d'autres transistors.

De préférence, le dispositif 100 comprend plusieurs transistors T110, plus préférentiellement répétés en matrice. Ainsi, les transistors sont répétés, dans l'exemple représenté, dans une première direction parallèle à la face avant, par exemple la direction des colonnes de la matrice, la première direction étant dans cet exemple orthogonale à la direction d'allongement des tranchées 170 et 170A.

De préférence, le dispositif 100 comprend des transistors T112 intercalés entre les transistors T110 voisins répétés dans la première direction, c'est-à-dire qu'une colonne comprend des transistors T110 et T112 répétés alternativement. Les transistors T112 sont symétriques aux transistors T110 par rapport à un plan orthogonal à la première direction. Dans l'exemple représenté, chaque tranchée 170 est commune à un des transistors T110 et un des transistors T112 agencés symétriquement de part et d'autre de la tranchée, la grille 120 et l'élément conducteur 180 étant communs à ces deux transistors. Dans cet exemple, la région semiconductrice 160, la zone de canal 130, et les zones dopées 140 et 150 sont communes à un des transistors T110 et un des transistors T112 agencés symétriquement de part et d'autre de la région semiconductrice 160, et, pour chacun de ces deux transistors, la tranchée 170 de l'un des deux transistors correspond à la tranchée supplémentaire 170A de l'autre des deux transistors.

Les transistors T110, et, de préférence, les transistors T112, sont également répétés (répétition non représentée) dans une deuxième direction parallèle à la face avant et orthogonale à la première direction, par exemple la direction de rangée de la matrice. La deuxième direction correspond ici à l'orientation droite-gauche des vues 1A, 1C, et 1D. De préférence, les colonnes voisines de la matrice sont symétriques par rapport à un plan orthogonal à la direction de rangée. Les régions semiconductrices 160 peuvent optionnellement être délimitées par des tranchées allongées dans la direction des colonnes (paroi de tranchées 195). En variante, les transistors sont répétés seulement dans la première direction ou seulement de la deuxième direction. Ceci n'est pas limitatif, le dispositif pouvant comprendre plusieurs transistors disposés différemment, ou une ou plusieurs paires de transistors T110 et T112 entre deux tranchées 170, 170A.

Dans un exemple préféré, les bornes 132, 142, 152 et 182 sont communes aux transistors T110 et/ou T112. Ainsi, les transistors T110 et/ou T112 sont électriquement en parallèle et sont commandés en parallèle, ce qui permet de faire passer par l'association des transistors en parallèle des courants élevés, c'est-à-dire de plus de 1 A, par exemple de plus de 5 A, voire de plus de 50 A. Une telle association correspond à un transistor composé des transistors élémentaires T110 et/ou T112. L'éventuel caisson enterré 190 est, de préférence, commun aux transistors T110 et/ou T112.

Ainsi, le transistor composé des transistors élémentaires T110 et/ou T112 permet le passage de courants élevés, et permet, comme ceci a été mentionné, d'améliorer le compromis entre la tension maximum bloquée et la résistance à l'état passant. Ceci est obtenu pour une surface particulièrement faible de substrat occupée par le transistor composé, par exemple, le transistor composé obtenu peut avoir, pour une tension maximum bloquée de l'ordre de 44 V, une résistance à l'état passant inférieure à 17 mΩ/mm².

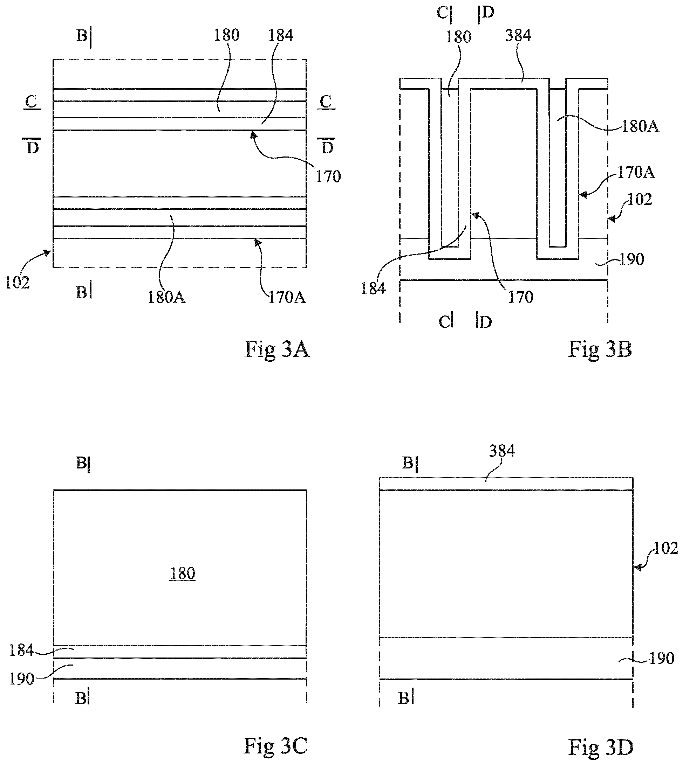

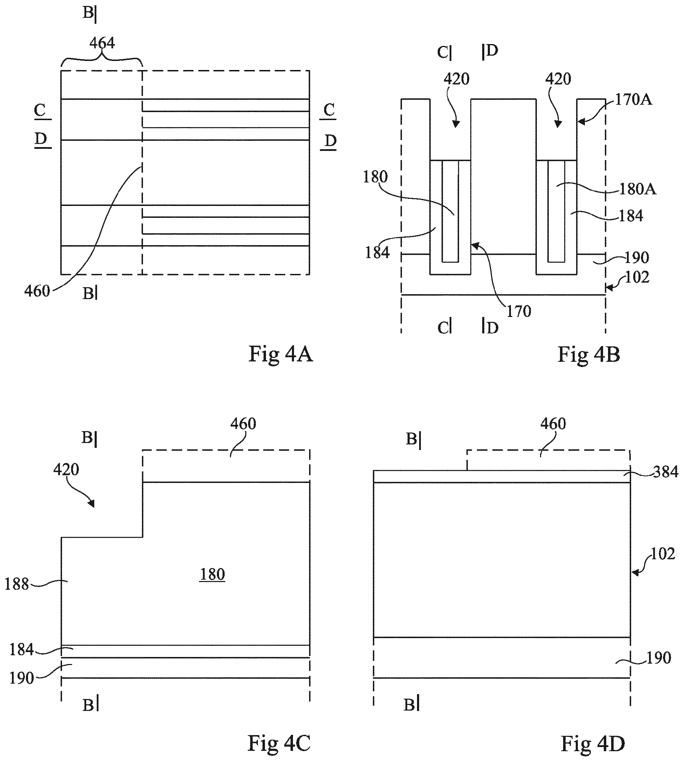

Les figures 3 et 4 illustrent, de manière partielle et schématique, des étapes d'un exemple de procédé de fabrication du dispositif 100 de la figure 1. Plus précisément, la figure 3 représente une vue de dessus 3A, et des vues en coupe 3B, 3C, et 3D à une même étape, et la figure 4 représente une vue de dessus 4A et des vues en coupe 4B, 4C et 4D à une autre étape. Les plans de coupe sont respectivement les mêmes que ceux de la figure 1.

A l'étape de la figure 3, on prévoit le substrat 102. Optionnellement, on forme le caisson enterré 190. Le caisson enterré 190 peut être formé à cette étape ou à une étape ultérieure du procédé.

On grave ensuite les tranchées 170, 170A dans le substrat, de préférence jusqu'à un niveau situé dans le caisson enterré. Après cela, on forme, sur les parois et le fond des tranchées, une couche électriquement isolante 384 dont des portions constitueront les futures couches isolantes 184 des transistors. A titre d'exemple, la couche est obtenue par un dépôt conforme recouvrant la structure résultant de la gravure des tranchées. La couche isolante 384 est de préférence en oxyde de silicium. L'épaisseur de la couche isolante 384 est inférieure à la demi-largeur des tranchées, en sorte de laisser un espace non rempli en partie centrale des tranchées.

Ensuite, on remplit l'espace restant des tranchées, de préférence par du silicium polycristallin dopé. Il en résulte les éléments conducteurs 180, 180A. A titre d'exemple, on recouvre de silicium polycristallin l'ensemble de la structure résultant du dépôt de la couche isolante, et on retire par gravure le silicium polycristallin situé au-dessus d'un niveau donné. Ce niveau donné est préférentiellement celui de la face avant du substrat, ou est situé à une hauteur inférieure à 10 nm au-dessus de la face avant du substrat. Il en résulte les murs conducteurs 180, 180A situés dans les tranchées.

A l'étape de la figure 4, aux emplacements 420 des grilles 120 et des isolants de grille 124, on retire les portions de la couche isolante 384 et du matériau conducteur des éléments 180. De préférence, pour cela, on a préalablement formé un masque 460 (représenté en pointillés) laissant accessible une partie 464 de la face supérieure de la structure. La partie 464 a en vue de dessus une forme de bande dont la direction principale, ou direction d'allongement, est orthogonale à la direction d'allongement des tranchées. Les portions du matériau conducteur des éléments 180 situées dans la bande 464 sont gravées sélectivement par rapport à la couche isolante 384 jusqu'au niveau supérieur des parties 188 des éléments conducteurs 180. La couche isolante 384 protège le substrat au cours de la gravure du matériau conducteur. Les portions de la couche isolante 384 rendues accessibles par la gravure du matériau conducteur sont ensuite gravées sélectivement par rapport au substrat 102.

A une étape ultérieure, non représentée, on forme l'isolant de grille sur les parois des tranchées 170 accessibles dans la bande 464. On forme, de préférence simultanément avec l'isolant de grille, les portions isolantes 186 destinées à isoler l'élément conducteur 180 des futures grilles 120. Ceci peut être obtenu par une oxydation thermique. On forme ensuite les grilles 120. La zone de canal 130, les zones dopées 134, 140, 150, et les sous-régions 166-i peuvent être formées par dopage du substrat 102 avant ou après les étapes décrites ci-dessus. Après cela, on forme les bornes 122, 132, 142, 152 et 182.

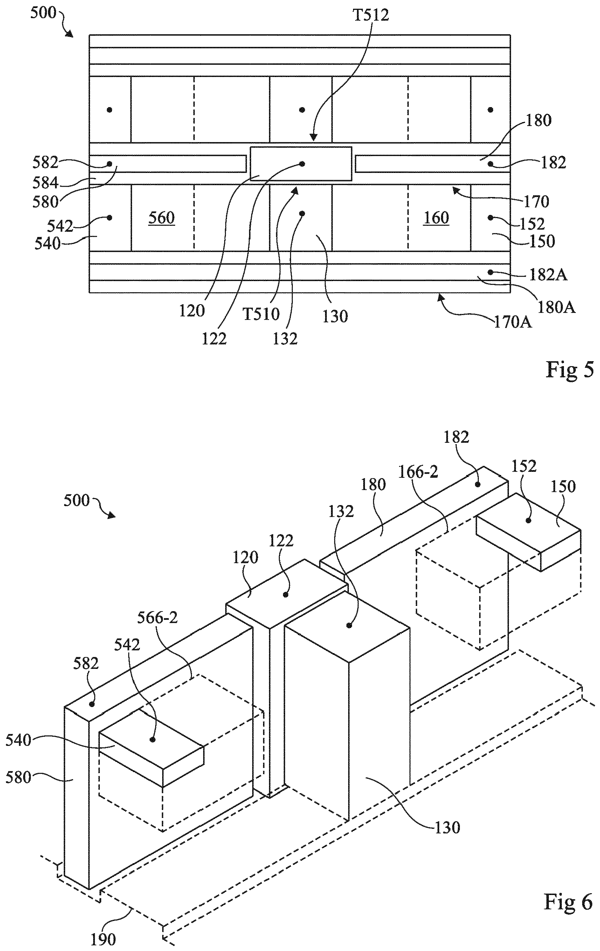

Les figures 5 et 6 sont respectivement une vue en coupe et une vue en perspective partielle, représentant schématiquement un mode de réalisation d'un dispositif 500 comprenant un ou plusieurs transistors, et, en particulier, un transistor T510. Le dispositif 500 comprend des éléments identiques ou similaires à ceux du dispositif 100 des figures 1 et 2, agencés de manière identique ou similaire. Ces éléments ne sont pas décrits à nouveau en détail, et seules les différences sont mises ici en exergue.

Le transistor T510 diffère du transistor T110 du dispositif 100 des figures 1 et 2 en ce que :
- la zone de canal 130 s'étend de la face avant du substrat 102 jusqu'au caisson enterré 190, c'est-à-dire qu'il atteint le caisson enterré. La région semiconductrice 160 est donc dépourvue de la partie 168 située sous la zone de canal ;
- le dispositif 500 comprend une région semiconductrice 560 en contact avec la zone de canal 130 et située du côté de la zone de canal 130 opposé à la région semiconductrice 160. Du fait que la zone de canal atteint le caisson enterré, les régions semiconductrices 160 et 560 sont isolées électriquement entre elles à l'état bloqué ;
- la zone dopée 140 de type N est remplacée par une zone dopée 540 de type N, de niveau de dopage élevé de sorte que la zone dopée 540 constitue une prise de contact électrique sur la région 560. La prise de contact 540 est connectée à une borne 542, de préférence connectée à la borne 132 de corps du transistor.

De préférence, l'élément conducteur 180 ne comprend pas de partie 188 située sous la grille 120. Plus préférentiellement, le transistor T510 comprend alors un élément conducteur 580 disposé dans la tranchée 170 du côté de la grille 120 opposé à l'élément conducteur 180. L'élément conducteur 580 est situé en vis-à-vis d'au moins une partie de la région semiconductrice 560, c'est-à-dire situé contre une couche isolante 584 située contre la région semiconductrice 560. L'élément conducteur 580 est connecté à une borne 582, de préférence connectée à la borne 182 de l'élément conducteur 180. En variante, l'élément conducteur 180 peut comprendre la partie 188 située sous la grille 120 et se prolonger par une partie 580 situé dans la tranchée 170 en vis-à-vis de la région semiconductrice 560.

De préférence, le transistor T510 présente un plan de symétrie orthogonal à la direction d'allongement des tranchées, ce plan de symétrie passant par la grille 120 et la zone de canal 130. En particulier, l'élément conducteur 580, la région 560 et la prise de contact 540 sont symétriques respectivement de l'élément conducteur 180, de la région semiconductrice 160 et de la zone dopée 150 par rapport au plan de symétrie.

Dans le cas préféré où le transistor T510 comprend une tranchée 170A et un élément conducteur 180A situé dans la tranchée 170A, l'élément conducteur 180A s'étend dans la tranchée 170A plus préférentiellement en vis-à-vis de la région semiconductrice 160, de la zone de canal 130, et de la région semiconductrice 560. Autrement dit, la tranchée 170 ne contient pas la grille d'un autre transistor.

Dans un exemple, le niveau de dopage est sensiblement uniforme dans chacune des régions semiconductrices 160 et 560, les niveaux de dopage de ces régions étant par exemple égaux. Dans un autre exemple, le dopage des régions semiconductrices 160 et 560 diminue à partir des prises de contact respectives 150 et 540. Les régions semiconductrices 160 et 560 peuvent alors comprendre par exemple respectivement des sous-régions 166-2 et 566-2 situées contre les prises de contact respectives 150 et 540, ces sous-régions ayant un niveau de dopage intermédiaire entre celui du reste des régions 160, 560 et celui des prises de contact 150 et 540.

La structure du transistor T510 permet, comme ceci a été mentionné dans le cas du transistor T110, d'optimiser le compromis entre la tension maximum à l'état bloqué, la résistance à l'état passant, et la surface de substrat (vue de dessus) occupée par le transistor.

De préférence, le dispositif 500 comprend en outre un transistor T512 symétrique du transistor T510 par rapport à la tranchée 170, la tranchée 170, la grille 600 et les éléments conducteurs 180 et 580 étant communs aux transistors T510 et T512.

De préférence, les transistors T510 et T512 sont connectés en parallèle et ont leurs bornes de commande 122 reliées ensemble, de préférence connectées ensemble.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art.

Enfin, la mise en oeuvre pratique des modes de réalisation et variantes décrits est à la portée de l'homme du métier à partir des indications fonctionnelles données ci-dessus.

## Revendications

1. Transistor (T110, T510) comprenant :
- une région semiconductrice (160) d'un substrat (102), délimitée par une tranchée (170) ;
- un élément électriquement conducteur (180) situé dans la tranchée (170) ;
- une zone de canal (130) en contact avec ladite région semiconductrice (160) ; et
- une prise de contact (150) avec ladite région (160), la zone de canal (130) et la prise de contact (150) étant du côté d'une même face du substrat.

2. Transistor (T110, T510) selon la revendication 1, dans lequel une partie (162) de la région semiconductrice (160) est située entre la zone de canal (130) et ladite prise de contact (150).

3. Transistor (T110, T510) selon la revendication 1 ou 2, dans lequel la région semiconductrice (160) est délimitée, d'un côté opposé à celui de ladite tranchée (170), par une tranchée supplémentaire (170A), et un élément électriquement conducteur supplémentaire (180A) est situé dans la tranchée supplémentaire (170A).

4. Transistor (T510) selon la revendication 3, dans lequel une partie de l'élément supplémentaire (180A) est en vis-à-vis de la zone de canal (130).

5. Transistor (T110, T510) selon l'une quelconque des revendications 1 à 4, comprenant une grille (120) située dans la tranchée (170).

6. Transistor selon l'une quelconque des revendications 1 à 5, dans lequel la tranchée (170) atteint un caisson enterré (190) .

7. Transistor (T110) selon la revendication 6, dans lequel une partie (168) de la région semiconductrice (160) est située entre la zone de canal (130) et le caisson enterré (190).

8. Transistor (T110) selon la revendication 7, dans lequel une partie (168) de l'élément conducteur (180) est située en vis-à-vis de ladite partie (168) de la région semiconductrice (160).

9. Transistor (T510) selon la revendication 6, dans lequel la zone de canal (130) atteint le caisson enterré (190).

10. Transistor (T510) selon l'une quelconque des revendications 1 à 9, comprenant, d'un côté de la zone de canal opposé à la région semiconductrice (160), une région semiconductrice supplémentaire (560) en contact avec la zone de canal (130), et une prise de contact supplémentaire (540) avec ladite région semiconductrice supplémentaire (560).

11. Transistor (T510) selon la revendication 10, comprenant un autre élément conducteur (580) situé dans la tranchée (170) en vis-à-vis de ladite région semiconductrice supplémentaire (560).

12. Transistor (T110, T510) selon l'une quelconque des revendications 1 à 11, dans lequel la région semiconductrice (160) présente, à partir de la prise de contact (150) avec ladite région (160), des niveaux de dopage décroissants.

13. Transistor (T110) selon l'une quelconque des revendications 1 à 12, comprenant une zone dopée (140) recouvrant une partie de la zone de canal (130), ladite zone dopée (140) étant de préférence reliée électriquement à l'élément conducteur (180).

14. Transistor (T110) selon la revendication 13, dans lequel ladite zone dopée (140) comprend une branche (144) s'étendant entre l'élément conducteur (180) et une prise de contact (134) avec la zone de canal (130).

15. Dispositif électronique (100, 500) comprenant un ou plusieurs transistors selon l'une quelconque des revendications 1 à 14.
